# EUROPEAN PATENT APPLICATION

(11) **EP 4 068 000 A1**
(43) Date of publication of application: **05.10.2022**
(21) Application number: 21165881.0
(22) Date of filing: 30.03.2021
(51) Int. Cl.: G03F 7/20

(54) **CONDITIONING APPARATUS AND METHOD**

(71) Applicant: ASML Netherlands B.V., 5500 AH Veldhoven (NL)
(72) Inventor: KOEVOETS, Adrianus Hendrik, 5500 AH Veldhoven (NL); VAN DER VOORT, Dennis Dominic, 5500 AH Veldhoven (NL); SBRIZZAI, Fabio, 5500 AH Veldhoven (NL)
(74) Representative: ASML Netherlands B.V.

(57) **Abstract**

There is provided an apparatus for conditioning a component of a lithography apparatus, the apparatus including: a housing configured to contain a hydrogen plasma; a hydrogen plasma generator configured to provide a hydrogen plasma to the component; wherein the apparatus is configured to control at least one of: the ratio of hydrogen ions to hydrogen radicals in the hydrogen plasma, the distance between the housing and the component being conditioned, and the energy of the plasma. Also described is a method of conditioning a surface of a component of a lithography apparatus, a lithography apparatus, and the use of such apparatuses or methods in a lithographic apparatus or process.

## Description

### FIELD

The present invention relates to an apparatus for conditioning a component of a lithography apparatus, a method for conditioning a component of a lithography apparatus, a lithography apparatus comprising an apparatus for conditioning a component of the lithography apparatus, and the use of such an apparatus or method in a lithographic apparatus or method. The present invention has particular, but not necessarily exclusive, application to EUV lithography.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

### SUMMARY

According to a first aspect of the present invention, there is provided anapparatus for conditioning a component of a lithography apparatus, the apparatus including: a housing configured to contain a hydrogen plasma; a hydrogen plasma generator configured to provide a hydrogen plasma to the component; wherein the apparatus is configured to control at least one of: the ratio of hydrogen ions to hydrogen radicals in the hydrogen plasma, the distance between the housing and the component being conditioned, and the energy of the plasma.

Within a lithography apparatus, the pressure is very low and under some conditions, surfaces can lack passivation. For example, wafer tables comprise an array of burls on which wafers rest whilst being imaged. The burls are essentially small pillars which support the wafer. The friction between the burls and the wafer varies depending on conditions and this creates a so-called wafer load grid, which is the distribution of load across a wafer. It is desirable for there to be hydrophobic material between the burls and the wafer as this results in reduced friction force or an otherwise reduced impact of friction between the two surfaces. In particular, a hydrophobic material reduces adhesion forces and capillary forces between the burls and the wafer under lithography conditions, particularly EUV lithography conditions. As a consequence of lower friction, the forces on the wafer are less and there is less in-plane deformation of the wafer. If the forces are too high, the wafer can become too deformed to correct and so the wafer is not able to be used. The burls may comprise diamond-like carbon (DLC). Depending on the relative humidity to which the DLC is exposed, it will have a greater or lesser degree of hydrogenation. The friction coefficient is inversely related to the degree of hydrogenation. As such, a hydrogen-free DLC surface has a greater coefficient of friction than a hydrogenated DLC surface, which in turn has a higher coefficient of friction than a more highly hydrogenated DLC surface. The layer of hydrogenation is typically very thin as it comprise a single hydrogen layer on the surface of the carbon lattice. In use, this hydrogenation can be worn off or can oxidize, leading to a surface having a higher coefficient of friction, which in turn leads to more deformation of the wafer as well as increased wear, resulting in degraded wafer clamp performance. The increased wear rate can also lead to greater adhesion between components. The apparatus of the first aspect of the present invention is configured to recondition a component of a lithography apparatus. By changing one or more of the ratio of hydrogen ions to hydrogen radicals in a hydrogen plasma, changing the distance between the housing and the component being conditioned, and the energy of the plasma, it is possible to carefully control the hydrogenation of the surface of the component and/or the oxidation/reduction of the surface of the component. Previously, hydrogen plasma was only used to remove material, such as carbon, from the surface and so there was no realization of the advantages of adjusting the conditions such that the surface was passivated by the provision of a hydrogen layer. If the same conditions used to clean a surface were used on a surface comprising carbon-based burls, this would also remove the burls, which is undesirable. Preferably, the apparatus is configured such that it includes a vacuum or near-vacuum. Preferably, the apparatus is configured to have a substantially water-free environment therein.

The ratio of hydrogen ions to hydrogen radicals may be altered as they have different reactivities. Hydrogen radicals are less reactive and are therefore etch more slowly. Hydrogen radicals therefore do not etch along stable planes of the DLC. Hydrogen ions are more reactive and are able to etch the more stable facets of the DLC. As such, hydrogen radicals reduce the height of asperities and increase the roughness of a surface, whereas hydrogen ions also reduce the height of asperities, but decrease roughness. In a cleaning operation, it is desired to remove contamination quickly and so the proportion of hydrogen ions to hydrogen radicals is increased, but this is not desired for reconditioning of surfaces and providing a passivated surface.

The reconditioning of the surface by hydrogen passivation can also be controlled by adjusting the distance between the housing and the component being conditioned and by adjusting the energy of the plasma. Again, when used for cleaning, the parameters are selected to provide the fastest rate of cleaning and there is no provision for altering the distance between the cleaning apparatus and the contaminant or adjusting the energy of the plasma. The energy of the plasma is relatively high so that the cleaning takes place quickly and the plasma is provided close to the contaminant again for rapid cleaning.

The apparatus may be configured to provide hydrogen plasma with an energy of from about 2 eV to about 40 eV, from about 4 eV to about 10 eV, preferably from about 4 to about 6 eV. This is lower than the energy used for contaminant removal. If the energy is higher than this, the incoming hydrogen plasma has sufficient energy to sputter carbon away from the surface, which would lead to increased wear and is undesirable when trying to provide a passivated layer with a low coefficient of friction. In addition, the sputtering might create a surface with undefined roughness and also the hydrogen does not contribute to the hydrogenation of the surface and the corresponding decrease in the coefficient of friction. Furthermore, there is a risk that high energy plasma might heat the surface too much and cause damage thereto.

The apparatus may include an electrical biasing unit configured to provide a potential difference between the housing and the component to control the energy of the hydrogen plasma provided to the component. Where the component is a wafer table, the wafer table comprises so-called Manhattan burls, which are electrically connected to ground. By applying a potential difference between the component and the hydrogen plasma housing, it is possible to tune the energy of the ions within the plasma and thereby control the passivation of the surface of the component. In addition, this allows for selection of the sign of the etching plasma molecule, especially if some oxygen or water is included for accelerated conditioning, it is possible to select the type, either positive or negative, of ions. For example, in the case of water, it is possible to select whether it is OH- or H+ ions impacting the surface. Furthermore, the efficiency may be increased since the charge will pull the ions towards the burls which represented around 1% of the total surface area. By providing an electrical bias, a larger fraction of ions are attracted specifically to the burls, making the conditioning or reconditioning faster.

The apparatus may include a controller to control the potential difference between the housing and the component being conditioned.

The housing may comprise one or more gas inlets. The one or more gas inlets may be configured to supply hydrogen and/or oxygen to the housing. The hydrogen plasma may be formed from hydrogen gas. The gas may or may not have a small amount of oxygen provided. The amount of oxygen may be less than about 5 vol%, less than about 4 vol%, less than about 3 vol%, less than about 2 vol%, or less than about 1 vol%. The presence of oxygen will accelerate the conditioning as graphiticised carbon (as opposed to DLC of the burls) can be removed. The amount of oxygen is controlled to remain at a level such that the gas remains a reducing gas such that the surface is passivated with a layer of hydrogenation. If there is too much oxygen, the surface could become oxidized, which would increase the coefficient of friction of the surface.

The apparatus may include a positioning device configured to position the housing to provide hydrogen plasma to the component being conditioned. The positioning device may be configured to allow the hydrogen plasma housing to move relative to the component being conditioned. In this way, the entire surface of the component being conditioned may be exposed to the hydrogen plasma and passivated. The positioning device may be configured to position the housing to within from about 1 mm to about 20 mm of a surface of the component being conditioned. By adjusting the separation of the hydrogen plasma housing and the surface of the component being conditioning, it is possible to control the degree of hydrogenation and therefore passivation of the surface.

The apparatus may be configured to include hydrogen gas at a pressure of from about 1 Pa to about 40 Pa, preferably from about 2 Pa to about 30 Pa.

The hydrogen plasma generator may be a radio-frequency plasma generator.

The apparatus may include one or more controllers to adjust the pressure and//or the composition of the gas within the apparatus. By adjusting the pressure and/or composition of the as within the apparatus, it is possible to control the passivation of the surface of the component being conditioned.

The component may be a wafer table. As described, a wafer table comprises a plurality of burls comprising diamond-like carbon (DLC), but may have micro- or nano-crystalline diamond coatings. It is desirable for the surface of the DLC or the micro- or nano-crystalline diamond coating to be passivated by the presence of hydrogen as this results in a lower coefficient of friction between the burls and a wafer which is positioned on the wafer table.

According to a second aspect of the present invention, there is provided a method of conditioning a surface of a component of a lithography apparatus, the method including: i) providing a hydrogen plasma housing configured to contain a hydrogen plasma; ii) providing a hydrogen plasma in the hydrogen plasma housing; iii) exposing the surface of the component of the lithography apparatus to the hydrogen plasma; wherein one or more of: the ratio of hydrogen ions to hydrogen radicals in the hydrogen plasma, the distance between the hydrogen plasma housing and the component, and the energy of the plasma are controlled to control the conditioning of the component.

By controlling the ration of hydrogen ions to hydrogen radicals in the hydrogen plasma, the distance between the hydrogen plasma housing and the surface of the component, and/or the energy of the plasma, it is possible to condition a surface of a component of a lithography apparatus. The conditioning may be passivation of the surface, resulting in a decreased coefficient of friction. In embodiments, there may be 1 to 40 Pa of hydrogen. Preferably, where there is gas other than hydrogen, it is a noble gas or oxygen.

The hydrogen plasma may have an energy of from about 2 eV to about 40 eV, from about 4 eV to about 10 eV, preferably from about 4 to about 6 eV. By controlling the energy of the hydrogen plasma, the method can be adjusted to provide the passivation of the surface without sputtering of atoms from the surface.

The method may include providing an electrical bias between the hydrogen plasma housing and the surface of the component and controlling the magnitude of the electrical bias to control the energy of the plasma. The magnitude of the electrical bias can be adjusted to adjust the energy of the hydrogen ions within the plasma. This can be used to control the passivation of the surface of the component.

The method may include moving the hydrogen plasma housing relative to the surface of the component. As such, they hydrogen plasma housing can be scanned across the surface of the component being conditioned such that the whole of the surface can be conditioned.

The method may include providing from about 0.1 vol% to about 5 vol% oxygen in the plasma, preferably from around 1 vol% to around 3 vol% oxygen in the plasma, or most preferably around 2 vol% oxygen in the plasma.

The provision of oxygen may allow the removal of contaminants from the surface to allow the passivation to occur more quickly. The oxygen may be provided in an amount such that the gas remains reducing so that the surface of the component is hydrogenated.

The method may include controlling a positioning device to position the hydrogen plasma housing such that the surface of the component is exposed to the hydrogen plasma. The method may include positioning the hydrogen plasma housing within from around 1 mm to around 20 mm of the surface of the component.

The method may include adjusting the pressure and/or power of the plasma to alter the relative amounts of hydrogen ions and hydrogen radicals in the plasma.

The method may include exposing the surface of the component to the plasma for less than 15 minutes, less than 10 minutes, less than 5 minutes, less than 3 minutes, less than 120 seconds, less than 90 seconds, or less than 80 seconds. The method may include exposing the surface of the component to the plasma for from around 1 second to around 75 seconds, preferably from around 30 seconds to around 60 seconds.

Since it is desired to passivate the surface rather than remove material from the surface, it is desirable to limit the time to which the surface is exposed to the plasma. The hydrogen passivation layer is only around one atom thick, so it is not required to expose the surface to the hydrogen plasma for extended periods of time.

According to a third aspect of the present invention, there is provided a lithographic apparatus comprising the apparatus according to the first aspect of the present invention. As such, the apparatus of the first aspect of the present invention may in some embodiments be included in the lithography apparatus, rather than as a stand-alone unit.

According to a fourth aspect of the present invention, there is provided the use of an apparatus according to the first or third aspects of the present invention or a method according to the second aspect of the present invention in a lithographic apparatus or method.

It will be appreciated that features described in respect of any aspect of the present invention may be combined with features of any other aspect of the present invention except where they are mutually incompatible. All combinations of each aspect of the present invention are contemplated.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source; and
- Figure 2 is a schematic depiction of an apparatus according to an embodiment of the present invention.

### DETAILED DESCRIPTION

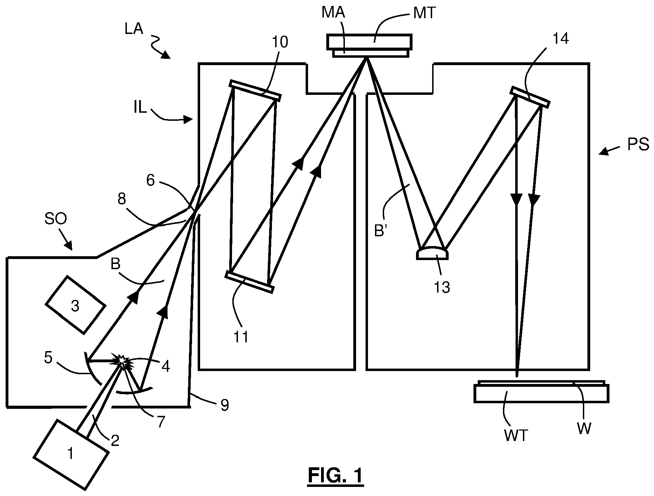

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W. The substrate table WT, also referred to as a wafer table, includes a plurality of burls which are configured to support substrate W. The burls may comprise diamond-like carbon (DLC).

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

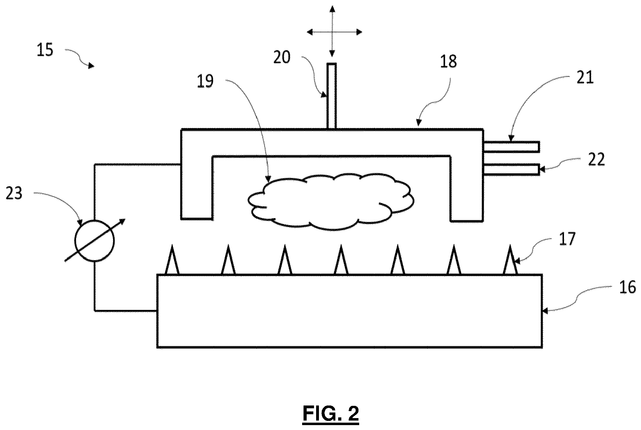

Figure 2 is a schematic depiction of an apparatus 15 for conditioning a component of a lithography apparatus and is depicted with reference to a wafer table 16 (also referred to as a substrate table WT) as the component being conditioned. The wafer table 16 includes a plurality of burls 17 which comprise diamond-like carbon. The apparatus 15 includes a housing 18 which is configured to contain hydrogen plasma. The housing 18 may be in the form of a cup and has at least one open face facing towards the wafer table 16. When in operation, the hydrogen plasma housing 18 contains a hydrogen plasma 19. The apparatus may comprise gas inlets 21, 22, which are configured to provide hydrogen and optionally oxygen gas to the hydrogen plasma housing. The apparatus 15 also includes a positioning device which can adjust the distance between the plasma housing 18 and the surface of the wafer table 16, and also translate the housing 18 relative to the surface of the wafer table 16 such that the burls 17 can be exposed to the hydrogen plasma 19 and thereby be passivated. An electrical connection 23 may be provided between the wafer table 17 and the housing such that an electrical bias can be provided and controlled to adjust the energy of the hydrogen ions within the plasma 19.

In use, a wafer table 16 comprising a plurality of burls 17 comprising diamond-like carbon is provided. A housing 18 is provided adjacent to the wafer table 16. Hydrogen gas, and optionally oxygen gas, is provided to the housing 18 whereupon it is converted into a plasma. The positioning device 20 is controlled such that the plasma 19 within the housing 18 interacts with the burls 17 and passivates the surface of the burls 17. The electrical bias between the wafer table 16 and the housing 18 is controlled to control the energy of the hydrogen ions within the hydrogen plasma 19 to control the degree of passivation of the burls 17. The housing 18 may be scanned across the surface of the wafer table 16 to ensure that the burls 17 are each exposed to the hydrogen plasma 19.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

### EXAMPLE

In order to demonstrate the utility of the present invention, a sample of oxidized diamond like carbon was taken and the contact angle of the sample was measured at different locations. The sample was then conditioned according to the present invention and the contact angle was measured again at the various different locations. The results of the experiments are provided in Table 1 below.

**Table 1**

| **Pre-treatment** | | **Post-treatment** | |
|---|---|---|---|
| **Sample** | **Contact Angle (°)** | **Sample** | **Contact Angle (°)** |
| 1 | 50 | 1 | 76 |
| 2 | 49 | 2 | 73 |
| 3 | 52 | 3 | 76 |
| 4 | 51 | 4 | 76 |
| 5 | 47 | 5 | 77 |

Furthermore, Table 2 provides XPS result of three DLC samples with different corrosion, treated with the same hydrogen plasma treatment according to the present invention. The post-plasma result is averaged over 3 positions.

**Table 2**

| **Sample** | **O₂ at t₀** | **O₂ post-corrosion** | **O₂ post-plasma** |
|---|---|---|---|
| 1 | 11.6 % | No data | 6.7 ± 0.1 % |
| 2 | 11.0 % | 14.5 % | 5.6 ± 0.1 % |
| 3 | 11.7 % | 20.4 % | 7.4 ± 0.5 % |

As can be seen from Table 2, the amount of oxygen present is reduced considerably following the treatment with plasma.

As can be seen from Table 1, prior to passivation according to the present invention, the contact angle was around 50°, but after treatment it was around 75°. This demonstrates the increase in hydrophobicity of the hydrogen-passivated DLC compared to oxidized DLC. The increase in hydrophobicity corresponds to a decrease in the coefficient of friction. As such, the apparatus of the present invention provides for a way of passivating the surface of a wafer table comprising burls comprising DLC or micro- or nano- crystalline diamond, which has the advantage of reducing stresses within a wafer supported by the wafer table. A reduction in stresses leads to lower deformation of the wafer. There has been no previous realization that the passivation of the surface of a wafer table comprising burls by hydrogenation can lead to a reduction in the deformation of a wafer supported thereby. The present invention provides an apparatus and a method for reducing the stresses on a wafer by passivating the surface of the wafer table with hydrogen.

### Clauses

11. A method of conditioning the surface of a component of a lithography apparatus, the method including:
   i) providing a hydrogen plasma housing configured to contain a hydrogen plasma;
   ii) providing a hydrogen plasma in the hydrogen plasma housing;
   iii) exposing the surface of the component of the lithography apparatus to the hydrogen plasma;
   wherein one or more of: the ratio of hydrogen ions to hydrogen radicals in the hydrogen plasma, the distance between the hydrogen plasma housing and the surface of the component, and the energy of the plasma are controlled to control the conditioning of the component.
12. The method according to clause 11, wherein the hydrogen plasma has an energy of from about 2 eV to about 40 eV, from about 4 eV to about 10 eV, preferably from about 4 to about 6 eV.
13. The method according to clause 11 or 12, wherein the method includes providing an electrical bias between the hydrogen plasma housing and the surface of the component and controlling the magnitude of the electrical bias to control the energy of the plasma.
14. The method according to any of clauses 11 to 13, wherein the method includes moving the hydrogen plasma housing relative to the surface of the component.
15. The method according to any of clauses 11 to 14, wherein the method includes providing from about 0.1 vol% to about 5 vol% oxygen in the plasma, preferably from around 1 vol% to around 3 vol% oxygen in the plasma, or most preferably around 2 vol% oxygen in the plasma.
16. The method according to any of clauses 11 to 15, wherein the method includes controlling a positioning device to position the hydrogen plasma housing such that the surface of the component is exposed to the hydrogen plasma, optionally wherein the method includes positioning the hydrogen plasma housing within from around 1 mm to around 20 mm of the surface of the component.
17. The method according to any of clauses 11 to 16, wherein the method includes adjusting the pressure and/or power of the plasma to alter the relative amounts of hydrogen ions and hydrogen radicals in the plasma.
18. The method according to any of clauses 11 to 17, wherein the method includes exposing the surface of the component to the plasma for less than 15 minutes, less than 10 minutes, less than 5 minutes, less than 3 minutes, less than 120 second, less than 90 seconds, or less than 80 seconds.
19. The method according to any of clauses 11 to 18, wherein the method includes exposing the surface of the component to the plasma for from around 1 second to around 75 seconds, preferably from around 30 seconds to around 60 seconds.

## Claims

1. An apparatus for conditioning a component of a lithography apparatus, the apparatus including:
a housing configured to contain a hydrogen plasma;
a hydrogen plasma generator configured to provide a hydrogen plasma to the component;
wherein the apparatus is configured to control at least one of: the ratio of hydrogen ions to hydrogen radicals in the hydrogen plasma, the distance between the housing and the component being conditioned, and the energy of the plasma.

2. The apparatus according to claim 1, wherein the apparatus is configured to provide hydrogen plasma with an energy of from about 2 eV to about 40 eV, from about 4 eV to about 10 eV, preferably from about 4 to about 6 eV.

3. The apparatus according to any preceding claim, wherein the apparatus includes an electrical biasing unit configured to provide a potential difference between the housing and the component to control the energy of the hydrogen plasma provided to the component.

4. The apparatus according of claim 3, wherein the apparatus further comprise a controller to control the potential difference between the housing and the component being conditioned.

5. The apparatus according to any preceding claim, wherein the housing comprises one or more gas inlets, optionally wherein the one or more gas inlets are configured to supply hydrogen and/or oxygen to the housing.

6. The apparatus according to any preceding claim, wherein the apparatus includes a positioning device configured to position the housing to provide hydrogen plasma to the component being conditioned, optionally wherein the positioning device is configured to position the housing to within from about 1 mm to about 20 mm of a surface of the component being conditioned.

7. The apparatus according to any preceding claim, wherein the apparatus is configured to include hydrogen gas at a pressure of from about 1 Pa to about 40 Pa, preferably from about 2 Pa to about 30 Pa.

8. The apparatus according to any preceding claim, wherein the hydrogen plasma generator is a radio-frequency plasma generator.

9. The apparatus according to any preceding claim, wherein the apparatus includes one or more controllers to adjust the pressure and/or the composition of gas within the apparatus.

10. The apparatus according to any preceding claim, wherein the component is a wafer table.

11. A method of conditioning the surface of a component of a lithography apparatus, the method including:
i) providing a hydrogen plasma housing configured to contain a hydrogen plasma;
ii) providing a hydrogen plasma in the hydrogen plasma housing;
iii) exposing the surface of the component of the lithography apparatus to the hydrogen plasma;
wherein one or more of: the ratio of hydrogen ions to hydrogen radicals in the hydrogen plasma, the distance between the hydrogen plasma housing and the surface of the component, and the energy of the plasma are controlled to control the conditioning of the component.

12. The method according to claim 11, wherein the hydrogen plasma has an energy of from about 2 eV to about 40 eV, from about 4 eV to about 10 eV, preferably from about 4 to about 6 eV.

13. The method according to claim 11 or 12, wherein the method includes providing an electrical bias between the hydrogen plasma housing and the surface of the component and controlling the magnitude of the electrical bias to control the energy of the plasma.

14. The method according to any of claims 11 to 13, wherein the method includes moving the hydrogen plasma housing relative to the surface of the component.

15. A lithographic apparatus comprising the apparatus according to any of claims 1 to 10.
